# EUROPÄISCHE PATENTSCHRIFT

(11) **EP 1 191 341 B1**
(45) Veröffentlichungstag und Bekanntmachung des Hinweises auf die Patenterteilung: **01.02.2006**
(21) Anmeldenummer: 01117161.8
(22) Anmeldetag: 14.07.2001
(51) Int. Cl.: G01R 31/02

(54) **Verfahren und Vorrichtung zum Ermitteln der Qualität eines Kabels**
Procedure and apparatus for determining the quality of a cable
Procédé et appareil pour déterminer la qualité d'un câble

(30) Priorität: 22.09.2000 DE 10047548
(43) Veröffentlichungstag der Anmeldung: 27.03.2002
(73) Patentinhaber: Hagenuk KMT Kabelmesstechnik GmbH, 01471 Radeburg (DE)
(72) Erfinder: Jung, Gerhard, 01277 Dresden (DE); Oertel, Eberhard, 01139 Dresden (DE)
(74) Vertreter: Hansmann, Dierk

(56) Entgegenhaltungen:
- US-A- 4 825 171

## Beschreibung

Die Erfindung betrifft ein Verfahren zum Ermitteln der Qualität und/oder des Wirkungsgrades eines Kabels bzw. einer Kabelstrecke über eine Strommessung eines Ableitstromes als parasitärer Querstrom.

Es ist bekannt, daß der parasitäre Querstrom als Ableitstrom zwischen einer stromführenden Ader eines Kabels und dem Kabelschirm, der im allgemeinen auf Massepotential liegt, den Wirkungsgrad/Qualität der Übertragungsstrecke vermindert. Durch Messen des Ableitstroms kann somit die Qualität der Kabelstrecke ermittelt bzw. ein entsprechendes Prüfkriterium aufgestellt werden. Je höher der Ableitstrom ist, desto geringer ist dabei die Qualität der Kabelstrecke.

zur Bestimmung des Ableitstromes., ist bereits vorgeschlagen worden, daß zwischen der Ader und dem Schirm des Kabels eine Gleichspannung als Prüfspannung angelegt wird und der fließende Strom gemessen wird. Zu diesem Zweck wird das Kabel freigeschaltet und mit einer der Spannungsebene entsprechenden Gleichspannung beaufschlagt sowie über ein Strommeßgerät der fließende Ableitstrom gemessen. Dieses Verfahren hat jedoch den Nachteil, daß die Gleichspannung Polarisationseffekte im Dielektrikum der Kabelisolation verursacht und dadurch die Gefahr einer Vorschädigung des Kabels besteht.

Weiterhin sind sogenannte VLF (very low frequency) -Prüfverfahren bekannt. Bei diesen Verfahren wird eine Wechselspannungsprüfung mit einer sehr niedrigen Frequenz von zum Beispiel 0,1 Hz durchgeführt. Die Phasensteilheit beim Polarisationswechsel entspricht dabei dem Frequenzspektrum von etwa 50 Hz. Ein wesentlicher Nachteil dieses-Verfahrens besteht jedoch darin, daß aufgrund der Überlagerung von Verlustkompensationen und Ableitstrom keine stetige Messung des Ableitstromes am Kabel möglich ist.

Weitere bekannte verfahren, wie zum Beispiel eine Resonanzprüfung, haben ebenfalls den Nachteil, daß eine kontinuierliche Messung des Ableitstroms nicht möglich ist, da bei diesen Verfahren kontinuierliche Umladeprozesse stattfinden und sich im Kabel keine stabilen Verhältnisse einstellen.

Der Erfindung liegt deshalb die Aufgabe zugrunde, ein Verfahren und eine Vorrichtung der eingangs genannten Art zu schaffen, mit dem die Qualität und/oder der Wirkungsgrad eines Kabels bzw. einer Kabelstrecke wesentlich zuverlässiger bestimmbar ist.

Gelöst wird diese Aufgabe mit einem Verfahren gemäß Anspruch 1 und einer Vorrichtung gemäß Anspruch 2.

weitere Einzelheiten, Merkmale und Vorteile der Erfindung ergeben sich aus der folgenden Beschreibung einer bevorzugten Ausführungsform anhand der schematischen Zeichnung. Es zeigen:
- Fig. 1: ein Prinzipschaltbild einer Meßanordnung und
- Fig. 2a und 2b: Strom- bzw. Spannungsverläufe der Meßanordnung.

Die dargestellte Schaltung umfaßt einen VLF-Generator 10, einen Spannungsmesser (Voltmeter) 11, einen Strommesser (Amperemeter) 12 sowie eine Analyse- und Auswerteeinheit 13. Der VLF-Generator 10 speist dabei ein Kabel 20, wobei ein Pol an der Ader 21 und der andere Pol an dem Schirm 22 des Kabels 20 anliegt. Mit dem Spannungsmesser 11 wird die an dem VLF-Generator 10 bzw. dem Kabel 20 anliegende Spannung gemessen, während der Strommesser 12 den in die Ader 21 eingespeisten Strom erfaßt. Die angemessenen Spannungs- und Stromwerte werden der Analyse- und Auswerteeinheit 13 zugeführt.

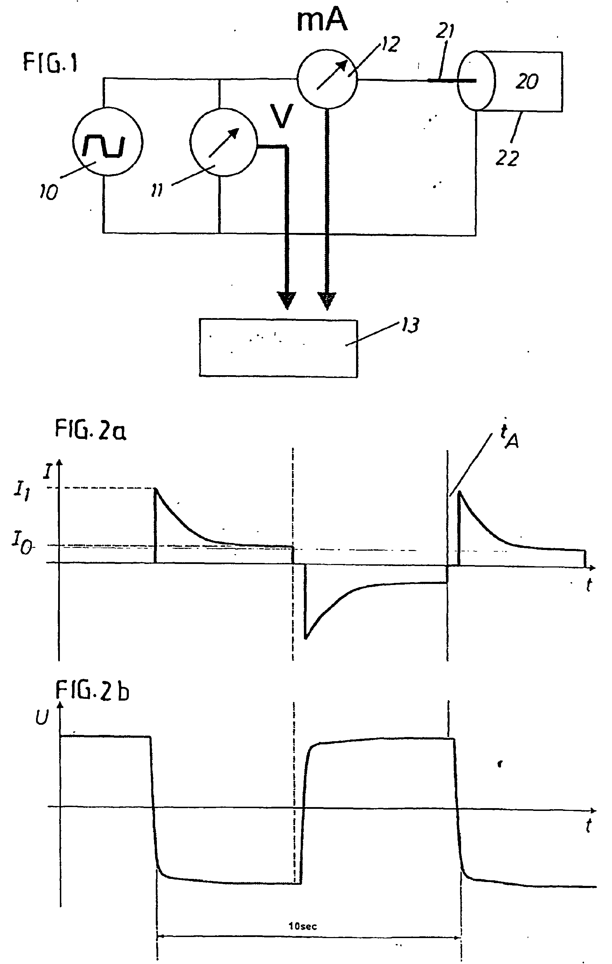

Der Verlauf der durch den VLF-Generator 10 erzeugten Spannung ist in Fig. 2b dargestellt. Der entsprechende Verlauf des dadurch verursachten Stroms in die Ader 21 des Kabels 20 ist in Figur 2a dargestellt. Wie in dieser Figur zu erkennen ist, steigt mit einem Polaritätswechsel der VLF-Spannung von positivem auf negatives Potential der Strom I auf einen maximalen Kabel-Ladestrom I₁ an und fällt dann bis auf einen Kabel-Leckstrom I₀ ab, bevor ein neuer Polarisationswechsel in umgekehrter Richtung einen entsprechenden Anstieg des Stroms in negativer Richtung verursacht.

Bei dieser VLF-Prüfung entspricht der Ableitstrom des Kabels dem Kompensationsstrom, der durch den VLF-Generator 10 kurz vor dem Polaritätswechsel (Umschwingprozesses) in das zu prüfende Kabel 20 eingespeist wird.

Die Analyse- und Auswerteeinheit speichert zu dem Zeitpunkt, zu dem sich die VLF-Spannung nicht mehr ändert (dU = 0), das heißt kurz vor dem Polaritätswechsel, den aktuellen Meßwert des Kabels-Leckstromes I₀, der dem Ableitstrom entspricht. In Figur 2a ist der Zeitpunkt mit "t_{A}" bezeichnet.

Der Ableitstrom wird somit punktuell über eine größere Zeitdauer gemessen und angezeigt. Durch den ständigen Wechsel der Polarität der an das Kabel angelegten VLF-Spannung wird ferner das Dielektrikum der Kabelisolation nicht geschädigt.

## Patentansprüche

1. Verfahren zum Ermitteln der Qualität und/oder des wirkungsgrades eines Kabels bzw. einer Kabelstrecke über eine Strommessung eines Ableitstromes als parasitärer Querstrom, **dadurch gekennzeichnet, daß** zwischen einer Ader (21) und einem Kabelschirm (22) des Kabels (20) eine Spannung (U_{VLF}) mit wechselnder Polarität angelegt wird, die im wesentlichen einen rechteckförmigen Verlauf hat und deren Periodendauer so gewählt ist, daß kurz vor einem Polaritätswechsel der Spannung ein dem Kabel entsprechender Strom in das Kabel fließt und das der Zeitpunkt bzw. die Steigung (dU = 0) zur Aktivierung der Messung genutzt wird.

2. Vorrichtung zur Durchführung des Verfahrens nach Anspruch 1, **gekennzeichnet durch** einen VLF-Generator (10) zur Erzeugung einer VLF-Spannung mit wechselnder Polarität mit einem im wesentlichen rechteckförmigen Verlauf, zum Anlegen an ein zu messendes Kabel (20), sowie einer Analyse- und Auswerteeinheit (13) zur Erfassung und Darstellung eines einen Ableitstrom in dem Kabel darstellenden Leckstroms kurz vor einem Polaritätswechsel der VLF-Spannung.

## Claims

1. Method for determining the quality and/or the efficiency of a cable or a cable section by way of current measurement of a leakage current as a parasitic cross current, **characterized in that** between a core (21) and a cable shield (22) of the cable (20) a voltage (U_{VLF}) of alternating polarity is applied, which has substantially a rectangular shape and of which the period of oscillation is selected such that shortly before a polarity change of the voltage, a current corresponding to the cable flows into the cable, and that the time and the gradient (dU = 0) are used to activate the measurement.

2. Device for executing the method according to claim 1, **characterized by** a VLF generator (10) for generating a VLF voltage of alternating polarity with a substantially rectangular shape, for applying to a cable (20) to be measured, as well as an analysis and evaluation unit (13) for detecting and representing a residual current representing a leakage current in the cable shortly before a polarity change in the VLF voltage.

## Revendications

1. Procédé pour déterminer la qualité et / ou le rendement d'un câble ou encore d'un segment de câble par l'intermédiaire d'une mesure d'un courant dérivé comme composante transversale parasite du courant, **caractérisé en ce qu'**on applique entre un brin (21) et un blindage (22) du câble (20) une tension (U_{VLF}) à polarité changeante qui a essentiellement un profil rectangulaire et dont la durée de période est choisie de telle manière que, peu avant un changement de polarité, un courant en relation avec le câble passe dans le câble et que le moment ou encore la pente (dU = 0) soit utilisé pour l'activation de la mesure.

2. Appareil pour mettre en oeuvre le procédé selon la revendication 1, **caractérisé par** un générateur VLF (10) pour produire une tension VLF à polarité changeante ayant un profil essentiellement rectangulaire à appliquer à un câble (20) à mesurer ainsi que par une unité d'analyse et d'évaluation (13) pour calculer et représenter un courant de fuite représentant un courant de dérivation dans le câble, peu avant un changement de polarité de la tension VLF.
